# EUROPÄISCHE PATENTSCHRIFT

(11) **EP 1 836 718 B1**
(45) Veröffentlichungstag und Bekanntmachung des Hinweises auf die Patenterteilung: **03.09.2008**
(21) Anmeldenummer: 06700748.4
(22) Anmeldetag: 11.01.2006
(51) Int. Cl.: H01J 37/32, H05H 1/24

(54) **MIKROPLASMAARRAY**
MICROPLASMA ARRAY
RESEAU A MICROPLASMA

(30) Priorität: 12.01.2005 DE 102005002142
(43) Veröffentlichungstag der Anmeldung: 26.09.2007
(73) Patentinhaber: Forschungsverbund Berlin e.V., 12489 Berlin (DE)
(72) Erfinder: GESCHE, Roland, 63500 Seligenstadt (DE)
(74) Vertreter: Hengelhaupt, Jürgen
(86) Internationale Anmeldenummer: PCT/EP2006/050157
(87) Internationale Veröffentlichungsnummer: WO 2006/075008

(56) Entgegenhaltungen:
- WO-A-00/65887
- WO-A-20/04024280
- US-A- 4 341 976
- US-A- 6 129 856
- GUO YOOU-BIN ET AL: "Radio-frequency microdischarge arrays for large-area cold atmospheric plasma generation" APPLIED PHYSICS LETTERS, AIP, AMERICAN INSTITUTE OF PHYSICS, MELVILLE, NY, US, Bd. 82, Nr. 3, 20. Januar 2003 (2003-01-20), Seiten 337-339, XP012034563 ISSN: 0003-6951
- BARÁNKOVÁ H ET AL: "Fused hollow cathode cold atmospheric plasma" APPLIED PHYSICS LETTERS, AIP, AMERICAN INSTITUTE OF PHYSICS, MELVILLE, NY, US, Bd. 76, Nr. 3, 17. Januar 2000 (2000-01-17), Seiten 285-287, XP012025681 ISSN: 0003-6951

## Beschreibung

Die Erfindung betrifft ein Mikroplasmaarray zur Erzeugung von Niedertemperatur-Plasmen bei Atmosphärendruck oder atmosphärennahen Drücken.

Plasmen werden bei vielen Sedimentations-, Ätz- und Schichtbildungsprozessen eingesetzt.

Bei Plasmareaktoren, die ein Niedertemperaturplasma erzeugen, wird entweder eine Hochfrequenzspannung von 10 bis 30 MHz im Vakuum auf zwei parallel Plattenelektroden aufgebracht oder man führt Mikrowellen im GHz-Bereich in eine Vakuumkammer ein, wobei Leistungen von mehr als 500 Watt erforderlich sind.

Jüngste Bestrebungen gehen dahin, geeignete Niedertemperaturplasmen auch unter Nichtvakuum-Bedingungen zu erzeugen. Derartige Reaktoren arbeiten mit Corona-Entladungen oder Glimmentladungen. Eine Übersicht über solche Plasmaerzeuger findet sich in Laroussi, Nonthermal Decontamination of Biological Media by Atmospheric-Pressure Plasmas: Review, Analysis, and Prospects, IEEE Transactions on Plasma Science, Vol. 30, No. 4, August 2002, S. 1409-1415 oder auch in Schütze et al., The Atmospheric-Pressure Plasma Jet: A Review and Comparison to Other Plasma Sources, a.a.O., Vol. 26, No. 6, December 1998. Die hier beschriebenen Plasmareaktoren sollen u. a. für biologische und medizinische Zwecke eingesetzt werden. Abgesehen von den Kosten, die bei Plasmareaktoren entstehen, die unter Vakuum arbeiten, verbietet sich in diesem Bereich oftmals die Anwendung von Unterdruck, so dass hier die Anwendung von Plasma bei Atmosphärendruck eine Voraussetzung ist. Auch eine Behandlung von vakuumempfindlichen Materialien wie bestimmte Polymere oder von empfindlichen Lebensmitteln wird mit Niedertemperaturplasmen bei atmosphärischem oder atmosphärennahen Drücken möglich.

Unter anderem als für die Plasmachirurgie oder für die Plasmazahnbehandlung geeignet wurden bereits sogenannte Plasmanadeln beschrieben, bei denen ein Plasma an einer Hochfrequenzelektrode in einem von einem Prozessgas durchströmten Zylinder erzeugt wird, siehe Stoffels et al., Plasma needle: a non-destructive atmospheric plasma source for fine surface treatment of (bio)materials, Plasma Sources Sci. Technol. 11 (2002, S. 383-388).

Das Bemühen, die Abmessungen von Plasmareaktoren für biologische und medizinische, aber auch für andere Zwecke zu reduzieren, hat zu sogenannten microstructured electrode arrays (MSE) geführt, die bei Spannungen unter 400 V im 10-MHz-Bereich mit kammartig strukturierten Elektroden arbeiten, siehe Baars-Hibbe et al., Micro-structured electrode arrays: Atmospheric pressure plasma processes - characterization and new applications, www.icpig.unigreifswald.de/proceedings/data/Baars-hibbe 1. Insbesondere für lichttechnische Anwendungen (Excimer-Laser, Leuchtstofflampen) sind Arrays als sogenannte MHCD-Geräte (microhollow cathode discharge) bekannt geworden. Hierbei werden in ein leitfähiges Kathodenmaterial Mikrolöcher eingebracht. Der zwischen den Mikrolöchern verbleibende Bereich ist mit einem Dielektrikum abgedeckt. Die gesamte. Kathode steht einer Anode gegenüber. Die Mikrolöcher werden für bestimmte Anwendungen als Sacklöcher ausgeführt (US 5 686 789) oder durchdringen die Kathode und ein darunter liegendes Substratmaterial (DE 198 21 244).

Aus WO 00/65 887 A ist ein MHCD-Array mit einer Anregung bis zu 100 MHz bekannt, das u. a. zur Behandlung von Substratoberflächen verwendet werden soll. Die Kathode, in die eine Anzahl von Hohlelektroden eingegracht ist, wird hierbei von einer an einer Seite von einer Ringanode umgeben.

Die bisher bekannte MHCD-Arrays arbeiten jedoch für Beschichtungsaufgaben noch nicht mit genügender Plasmadichte.

Der Erfindung liegt die Aufgabe zugrunde, ein Mikroplasmaarray der eingangs genannten Art anzugeben, das geeignet ist, einen Gasstrom mit einer hohen Effizienz zu aktivieren, und ein Plasma hoher Dichte zu generieren, das vom Gasstrom durchströmt wird.

Erfindungsgemäß wird die Aufgabe gelöst durch die Merkmale des Anspruchs 1. Zweckmäßige Ausgestaltungen sind Gegenstand der Unteransprüche.

Danach besteht das Array aus einem Substrat, in das in regelmäßigen Abständen voneinander Löcher eingebracht sind. Die Wände der in das Substrat eingebrachten Löcher sind, Hohlelektroden bildend, metallisch beschichtet. Diese Hohlelektroden werden einzeln..oder gruppenweise von einer Seite des Substrates mit einer elektrischen Anregung im GHz-Bereich versorgt, wobei auf der Seite der Zuführung der elektrischen Anregung auf dem Substrat die jeweilige Anregung liefernde Oszillatoren integriert sind.

Die Verwendung von Höchstfrequenzen hat den Vorteil, dass eine hohe Plasmadichte erreicht und das Zündverhalten des Plasmas verbessert wird.

Zweckmäßig haben die Hohlelektroden einen zylindrischen Querschnitt, können gegebenenfalls aber auch andere Querschnittsformen aufweisen. Der Durchmesserbereich der Hohlelektroden sollte bevorzugt zwischen 1µm und 1 mm liegen, wobei die Länge der Hohlelektroden im Bereich zwischen 100 µm und 10 mm liegen kann.

Für spezielle Anwendungen können die metallischen Wände der Hohlelektroden mit einer isolierenden Beschichtung versehen sein, insbesondere wenn das Elektrodenmaterial kann den Prozess chemisch stören würde. Weiterhin könnte es auf der Elektrode Überschläge geben. Die Beschichtung hilft, solche zu vermeiden und zu löschen und reduziert damit den Verschleiß der Elektrode.

Zur Verbesserung des Zündverhaltens des Plasmaarrays kann an der der Zuführung der elektrischen Anregung gegenüberliegenden Seite des Substrates eine weitere, mit Löchern versehene Elektrode angeordnet ist, wobei diese Löcher im wesentlichen mit der Lage und dem Durchmesser der Hohlelektroden korrespondieren. Der Abstand der Hohlelektroden zu der weiteren Elektrode sollte möglichst gering sein und nicht größer als 500 µm gewählt werden. Der Abstand kann zum Beispiel durch eine zwischengelegte Isolierschicht realisiert werden.

Als Substratmaterial kann zweckmäßig Keramik oder ein Keramik-Compound (z. B. Duroid, Standard-Mikrowellen-Platinenmaterial) verwendet werden. Bei zukünftiger Integration sind auch Halbleitermaterialien denkbar. Die Löcher werden entweder mit einem Laser hergestellt oder durch eine (Photolack-)Maske (plasma)chemisch geätzt. Die Hohlelektrode selbst wird dann durch galvanische oder Vakuumbeschichtung (PVD, CVD) hergestellt.

Die die jeweilige Anregung liefernden Oszillatoren werden mit auf dem Substrat integriert, und zwar zweckmäßig auf der Seite der Zuführung der elektrischen Anregung, wobei die Hohlelektroden einen Teil des Schwingkreises bilden.

Dadurch, dass sich die Plasmazellen des Mikroplasmaarrays einzeln oder gruppenweise ansteuern lassen, ist eine strukturierte Behandlung von Oberflächen möglich. Das Plasma kann auch relativ zur Oberfläche des Behandlungsobjekts bewegt werden. Ebenfalls möglich ist die Behandlung von ihrerseits bewegten Behandlungsobjekten durch die Mitbewegung des Plasmas mit dem bewegten Objekt, so dass das Plasma trotz der Bewegung des Objekts nur in einem bestimmten Bereich einwirkt.

Ein nach der Erfindung hergestelltes Plasmaarray ist verwendbar zum Beispiel für
- Plasmaquellen für die in-situ-Sterilisation von (Lebensmittel-)Verpackungen, medizinischen Geräten und Gewebe,
- die Funktionalisierung und Beschichtung im Bereich biomedizinischer Anwendungen und Diagnostiksysteme, z. B. in den Bereichen Tissue Engineering, medikamentenabgebende Implantate
- Plasma-Strahlungsquellen für gesundheitsfördernde Lichtsysteme, UV-Quellen für die Entkeimung
- mobile Anwendungen im Haushalt- und Freizeitbereich, z. B. für die Entfernung von organischen Verunreinigungen in Haushalttextilien, die Geruchsbeseitigung in Wohnung und Auto
- funktionelle Oberflächenveredlungen von Verpackungen, Kunststoffen, Glas und textilen Geweben
- die Herstellung und Veredlung von Nanopulvern für diagnostische Zwecke oder zur Erzeugung komplexer Materialien
- die Herstellung von dünnen Schichten, z. B. an aufrollbaren oder geformte Solarzellen oder Dünnschichtsensoren

Die Erfindung soll nachstehend anhand eines Ausführungsbeispiels näher erläutert werden. In den zugehörigen Zeichnungen zeigen
- Fig. 1: die Ansicht auf ein erfindungsgemäßes Plasmaarray und
- Fig. 2: einen Querschnitt durch eine einzelne Zelle eines solchen Plasmaarrays.

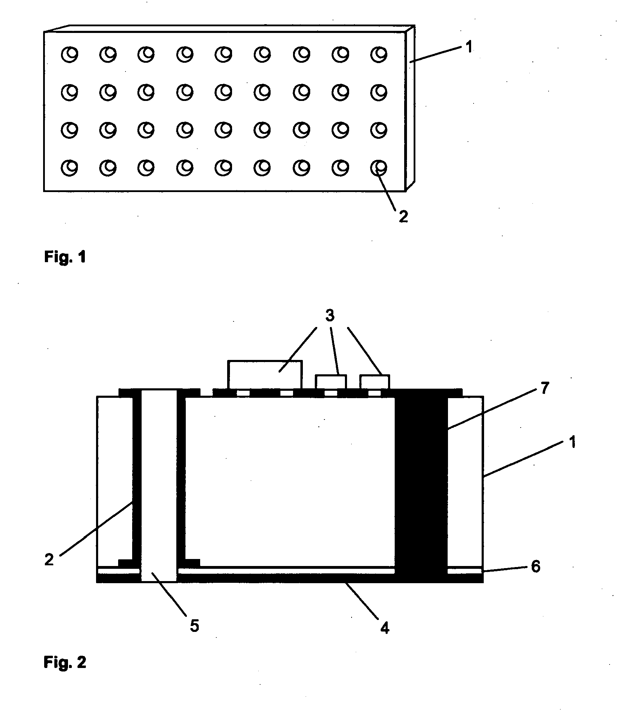

Fig. 1 zeigt eine Gesamtansicht eines erfindungsgemäßen Plasmaarrays mit 4x9 einzelnen Plasmazellen, die durch in ein Substrat 1 eingebrachte Hohlelektroden 2 charakterisiert sind.

Fig. 2 zeigt in einer Querschnittsansicht eine einzelne Plasmazelle. Die Hohlelektrode 2 wird durch eine metallische Beschichtung eines in das Substrat 1 eingebrachten Mikroloches gebildet. Das Einbringen der Löcher und deren Beschichtung erfolgt mit aus der Halbleitertechnik bekannten Methoden. An der Oberseite des Substrates 1 ist die Hohlelektrode 2 mit einem in das Substrat 1 integrierten, frei schwingenden Oszillators 3 verbunden, der beispielsweise für eine Anregung mit einer Frequenz von 5,8 GHz ausgelegt ist (ISM-Frequenz). Mit der Anordnung von Oszillatoren 3 direkt auf dem Substrat 1 wird das Array zu einem völlig selbständigen Bauelement, das lediglich einer Spannungszuführung bedarf. Die Leistung einer einzelnen Plasmazelle lässt sich auf weniger als 10 Watt beschränken, so dass Plasmen mit sehr geringem Energieeintrag ermöglicht werden, wobei außerdem die Möglichkeit der gruppenweisen oder sogar einzelnen Ansteuerung von Plasmazellen eine gute Skalierbarkeit gewährleistet ist.

Das Substrat 1 besteht aus einem 500 µm dicken Keramikmaterial, zum Beispiel Duroid. Die Hohlelektroden 2 haben einen Durchmesser von 100 µm. Sie können zusätzlich, wie oben angesprochen, durch eine isolierende Beschichtung passiviert sein.

Um bei einer Anregung eine sofortige Zündung des Plasmas in den Hohlelektroden 2 zu gewährleisten, ist auf die Unterseite des Substrates 1 zusätzlich eine weitere Elektrode 4 (Anode) aufgebracht, die an mit den Hohlelektroden 2 korrespondierenden Stellen Löcher aufweist, so dass sich jeweils ein Zündspalt 5 bildet. Die Elektrode 4 ist mit Massepotential verbunden. Die Verbindung zum Massepotential an der Oberseite des Substrates erfolgt zweckmäßig über eine Masseverbindung 6 durch ein weiteres Loch im Substrat 1. Die Herstellung der Masseverbindungen 6 erfolgt analog zur Herstellung der Hohlelektroden 2. Die Masseverbindung 6 könnte hohl sein oder galvanisch gefüllt werden oder in einem weiteren Arbeitsschritt mit Lötzinn gefüllt werden.

Der Zündspalt 5 wird durch eine zwischen der Elektrode 4 und dem Substrat 1 zusätzlich aufgebrachte Isolierschicht 6 gewährleistet. Die Isolierschicht 6 hat eine Dicke von etwa 20 µm und besteht ebenfalls aus einem Keramikmaterial.

Beim Zünden werden freie Elektronen, die in geringer Dichte immer vorhanden sind, soweit beschleunigt, dass sie bei Kollisionen mit Gasmolekülen energiereich genug sind, um weitere Elektronen aus den Gasmolekülen herauszuschlagen. Dabei entstehen weitere freie Elektronen (Lawineneffekt) und Ionen. Unter geeigneten Parametern (Gasart, Druck, Feldstärke) steigt die Ionisierung auf einen Gleichgewichtswert, bei dem die neue Stoßionisation gleich den Elektronenverlusten wird. Die Elektronenverluste entstehen durch Rekombination (mit Licht, UV, IR-Emmission) und durch Wandverluste (Elektronen verlassen den Plasmabereich). Für das Zünden ist eine hohe Feldstärke erforderlich, die bei limitierter Spannung durch einen kleinen Abstand erzeugt werden kann, hier durch den kleinen Zündspalt 5. Nach der Zündung bildet das Plasma ein leitfähiges Medium mit einem äußerst komplexen Verhalten. Es soll mach der Zündung nicht im Zündspalt lokalisiert bleiben, da dann bei kleinem Volumen und hoher Temperatur die Belastung der Elektroden sehr groß würde, ein Problem, das bei allen "bipolaren" Anordnungen auftritt. Es soll sich in die Hohlelektrode 2 ausbreiten und diese weitgehend ausfüllen, wobei sich eine Koaxialleitungsstruktur bildet (die Elektrode ist der Außenleiter, das Plasma ist der Innenleiter).

### Liste der Bezugszeichen

- 1: Substrat
- 2: Hohlelektrode
- 3: Oszillator
- 4: Elektrode
- 5: Zündspalt
- 6: Isolierschicht
- 7: Masseverbindung

## Patentansprüche

1. Mikroplasmaarray zur Erzeugung von Niedertemperatur-Plasmen bei Atmosphärendruck oder atmosphärennahen Drücken, wobei
die Wände von in regelmäßigen Abständen voneinander in ein Substrat (1) eingebrachten Löchern, Hohlelektroden (2) bildend, metallisch beschichtet sind, **dadurch gekennzeichnet, dass** diese Hohlelektroden (2) einzeln oder gruppenweise von einer Seite des Substrates (1) mit einer elektrischen Anregung im GHz-Bereich versorgt..sind, wobei auf der Seite der Zuführung der elektrischen Anregung auf dem Substrat (1) die jeweilige Anregung liefernde Oszillatoren (3) integriert sind.

2. Mikroplasmaarray nach Anspruch 1, **dadurch gekennzeichnet, dass** die Hohlelektroden (2) einen zylindrischen Querschnitt aufweisen.

3. Mikroplasmaarray nach Anspruch 1 oder 2, **dadurch gekennzeichnet, dass** der Durchmesser der Hohlelektroden (2) kleiner als 1 mm ist.

4. Mikroplasmaarray nach einem der Ansprüche 1 bis 3, **dadurch gekennzeichnet, dass** die..metallischen Wände der Hohlelektroden (2) mit einer isolierenden Beschichtung versehen sind.

5. Mikroplasmaarray nach einem der vorhergehenden Ansprüche, **dadurch gekennzeichnet, dass** an der der Zuführung der elektrischen Anregung gegenüberliegenden Seite des Substrates (1) eine mit Löchern versehene Elektrode (4) angeordnet ist, wobei diese Löcher im wesentlichen mit der Lage und dem Durchmesser der Hohlelektroden (2) korrespondieren.

6. Mikroplasmaarray nach Anspruch 5, **dadurch gekennzeichnet, dass** der Abstand der Hohlelektrode (2) zu der weiteren Elektrode (4) kleiner als 500 µm ist.

## Claims

1. Microplasma array for producing low-temperature plasmas at atmospheric pressure or at close to atmospheric pressures,
wherein
the walls of holes which are introduced into a substrate (1) at regular intervals from each other, forming hollow electrodes (2), are metal-coated, and said hollow electrodes (2) are supplied individually or in groups with electrical excitation in the GHz-range from one side of the substrate (1), wherein oscillators (3) which supply the respective excitation are integrated on the side of the supply of the electrical excitation on the substrate (1).

2. Microplasma array according to claim 1, **characterized in that** the hollow electrodes (2) have a cylindrical cross-section.

3. Microplama array according to claim 1 or 2, **characterized in that** the diameter of the hollow electrodes (2) is less than 1 mm.

4. Microplasma array according to one of claims 1 to 3, **characterized in that** the metallic walls of the hollow electrodes (2) are provided with an insulating coating.

5. Microplasma array according to one of the preceding claims, **characterized in that** an electrode (4) which is provided with holes is disposed at the side of the substrate (1) opposite to the supply of the electrical excitation, wherein said holes substantially correspond to the position and the diameter of the hollow electrodes (2).

6. Microplasma array according to claim 5, **characterized in that** the distance of the hollow electrodes (2) to the further electrode (4) is less than 500 µm.

## Revendications

1. Réseau à microplasma destiné à créer des plasmas basse température à pression atmosphérique ou à des pressions à peu près atmosphériques,
dans lequel
les parois de trous pratiqués à écarts réguliers dans un substrat (1), formant des électrodes creuses (2), sont revêtues de métal, et lesdites électrodes creuses (2) sont soumises, par un côté du substrat (1), individuellement ou en groupe, à une excitation électrique dans la gamme des GHz, des oscillateurs (3) qui fournissent l'excitation respective étant intégrés sur le substrat (1), du côté de l'alimentation en excitation électrique.

2. Réseau à microplasma selon la revendication 1, **caractérisé en ce que** les électrodes creuses (2) ont une section transversale cylindrique.

3. Réseau à microplasma selon la revendication 1 ou 2, **caractérisé en ce que** le diamètre des électrodes creuses (2) est inférieur à 1 mm.

4. Réseau à microplasma selon l'une des revendications 1 à 3, **caractérisé en ce que** les parois métalliques des électrodes creuses (2) sont pourvues d'un revêtement isolant.

5. Réseau à microplasma selon l'une des revendications précédentes, **caractérisé en ce qu'**une électrode (4) pourvue de trous est disposée du côté du substrat (1) opposé à l'alimentation en excitation électrique, lesdits trous correspondant substantiellement à la position et au diamètre des électrodes creuses (2).

6. Réseau à microplasma selon la revendication 5, **caractérisé en ce que** l'écart séparant les électrodes creuses (2) de l'autre électrode (4) est inférieur à 500 µm.
